# EUROPEAN PATENT SPECIFICATION

(11) **EP 3 982 047 B1**
(45) Date of publication and mention of the grant of the patent: **10.12.2025**
(21) Application number: 20201207.6
(22) Date of filing: 12.10.2020
(51) Int. Cl.: F24C 15/10, F24C 7/08, H05B 6/12, H01R 12/73, H01R 12/71, H01R 12/70, A47L 15/42, D06F 34/28, H05B 6/64, H05K 1/14, H05K 7/14

(54) **HOUSEHOLD APPLIANCE AND METHOD FOR ESTABLISHING AN ELECTRICAL CONNECTION OF A PRINTED CIRCUIT BOARD IN SAID APPLIANCE**
HAUSHALTSGERÄT UND VERFAHREN ZUR HERSTELLUNG EINER ELEKTRISCHEN VERBINDUNG EINER LEITERPLATTE IN EINEM SOLCHEN HAUSHALTSGERÄT
APPAREIL DOMESTIQUE ET PROCÉDÉ D'ÉTABLISSEMENT D'UNE CONNEXION ÉLECTRIQUE D'UN CIRCUIT IMPRIMÉ DANS LEDIT APPAREIL

(43) Date of publication of application: 13.04.2022
(73) Proprietor: Electrolux Appliances Aktiebolag, 105 45 Stockholm (SE)
(72) Inventor: BAYERLEIN, Stefan, 91541 Rothenburg ob der Tauber (DE); HÄUTLE, Ulrich, 91541 Rothenburg ob der Tauber (DE); KLEIN, Gerhard, 91541 Rothenburg ob der Tauber (DE)
(74) Representative: Electrolux Group Patents

(56) References cited:
- EP-A1- 0 974 176
- EP-A2- 0 841 752
- EP-A2- 0 924 971
- EP-A2- 0 930 467
- WO-A1-2015/068093
- US-A1- 2017 016 622
- US-A1- 2019 190 207
- US-B2- 9 017 115

## Description

The present invention relates to a household appliance, particularly a cooking appliance, more particularly a cooking hob, even more particularly an induction cooking hob, comprising an electric or electronic component according to the preamble of claim 1. The present invention also relates to a method for establishing an electrical connection of an electric or electronic component, particularly a printed circuit board, of a household appliance according to claim 10.

Generally, household appliances are assembled from modular components, which may be individual parts, e.g. motors, heating elements, pumps, or the like, or systems or subsystems, which themselves may be an assembly of single parts, e.g. printed circuit boards like control units or user interfaces. A relevant number of said modular components is of electrical nature, which modular components have to be supplied with electrical energy and which are electrically connected with other electrical components for information and/or power transfer. In production facilities for household appliances, nowadays, there is already an advanced level of automation, which is reflected in an automated assembly of components, for example arrangeable in a housing of the household appliance. However, there are still manual assembly steps required for establishing electrical contacts, particularly by connecting plug contacts of wiring harnesses.

EP-A-0930467 discloses a household appliance comprising a cooking appliance panel and coming along with a reduced assembling time.

US-A-2017016622 discloses a cooking hob having a control device, which aims on guaranteeing contact between electrical contacts even over prolonged times.

WO-A-2015068093 describes a cooking hob having a display device arranged in an edge region of the cooking hob so as to limit temperature influences on the display unit.

US-B-9017115 discloses a demountable control panel for an electrical motor drive.

EP-A-0841752 discloses a household appliance provided with a control group, which allows being easily adapted to specific requests of the costumers.

EP-A-0924971 discloses means of contacting of circuit boards, which are arranged within a housing.

It is an object of the present invention to provide a household appliance, which is constructed in such a way that the level of automation in production facilities of household appliances can be further increased by simultaneously reducing assembly errors. It is a further object of the present invention to provide a method for establishing an electrical connection of an electric or electronic component of a household appliance, which supports an advanced level of automation by reducing assembly errors on an assembly line for a household appliance.

The object is achieved by a household appliance according to claim 1.

The household appliance according to the present invention comprises a printed circuit board, which is connected to a connection line for electrical connection for power and/or information transmission. The printed circuit board comprises a first connection means and the connection line comprises a second connection means for the interconnection of first and second connection means. In this respect, the first and second connection means are favourably compatible with one another. According to the present invention, the connection line is fixedly attached at least in the area of the second connection means to a carrier element. Moreover, the carrier element and the printed circuit board are arranged inside or at the household appliance in a way that the connection is established by defined positions and orientations of the carrier element and the printed circuit board relative to each other.

The connection line electrically interconnects a first circuit board and a second circuit board, which are arranged one above the other in a common housing. The connection line, which is guided along a housing side wall, or any other particularly vertically arranged wall or support means, from the first to the second circuit board for interconnecting the two circuit boards. Said other particularly vertically arranged wall or support means may be an inner wall or a support wall that may be arranged inside said common housing, preferably adjacent to the housing side wall.

A lower end section of the connection line is arranged on a bottom wall of said common housing, on which at least the lower one of the first and second circuit boards is supported, and at least a part thereof forms the second connection means. Said second connection means is electrically contacted from above by a spring forming the first connection means. The spring protrudes downwardly from a bottom side of the lower one of the first and second circuit boards, and may be a spiral spring.

Alternatively, also a leaf-spring or any other flexible and preferably conductive element may be used.

Due to the fixed attachment of the connection line, notably at least at the area or section of interconnection, to the carrier element and due to a clear positioning of the carrier element within the household appliance, particularly by means of its fixation to or its inclusion in a housing or frame part of the household appliance, also a defined position of the connection area of the connection line, and specifically also of the second connection means, is realized. Preferably, the electric or electronic component includes a stationary arrangement of the first connection means, so that with the carrier element and the electric or electronic component having defined positions and orientations relative to each other, also defined positions of the connection pair, i.e. of the first and second connection means, are established.

The household appliance is particularly a cooking appliance and may be a cooking hob, in particular an electrically driven cooking hob. A specifically selected appliance is an induction cooking hob.

The electric or electronic component is or comprises a circuit board. The carrier element is preferably rigid or inflexible, and it may be a housing or frame part or carrier body, specifically for the circuit board.

The connection between the first and the second connection means is particularly a plug-and-socket connection or a connection between contact points or contact surfaces. A contact pressure is provided in order to ensure a secure electrical connection, so that the transition resistance is particularly low. Preferably, at least one of the first and second connection means is spring suspended, in that providing for a specifically increased contact pressure, further supporting said secure connection. According to a preferred aspect of the present invention, the first connection means is a contact point or contact surface arranged on a conductor track of a circuit board. Advantageously, the conductor track comprises a particularly conductive material or surface at least in the area of the electrical connection. The electrical connection is preferably designed to provide an installation condition with a two-dimensional, more preferably a three-dimensional, tolerance compensation.

A specifically preferred embodiment of the present invention provides for a connection line that is a conductor track or a metal strip. Insofar, the metal strip may form a conductor rail. The conductor track or the metal strip is arranged on an electrically non-conductive surface of the housing or frame part or carrier body and particularly comprises a copper material. Preferably, said material is a copper-zinc composition. A particularly favourable solution is characterized by a conductor track, which is applied onto the non-conductive surface by a metallic coating process.

The housing or frame part or carrier body is preferably made of a non-conductive material, at least in the area of the arrangement of the connection line. A preferred solution proposes the use of a plastic material.

In order to provide electrical connection extensively or even completely by using the subject matter of the present invention, a plurality of at least two conductor tracks or metal strips may be provided. Said plurality of conductor tracks or metal strips is preferably arranged in parallel to each other. Additionally or alternatively to the parallel arrangement, the conductor tracks or metal strips are separated by a partition, particularly a partition or separation wall, what is advantageous in cases where a higher voltage is applied to at least one of the conductor tracks or metal strips, e. g. in the case of power supply to the electric or electronic component.

In addition to the solution for the lower end section, an upper end section of the connection line, particularly of the conductor track or the metal strip, may be arranged on an upper abutting face of a housing side wall or of an inner wall or support element. The upper end section and/or the upper abutting face forms or form an abutment face for the first connection means and particularly also for an outer edge of the upper one of the first and second circuit boards.

One embodiment of the invention is characterized in that the upper one of the first and second circuit boards is a user interface and the lower one is a power board of the household appliance. The user interface is pressed against an upper plate of the household appliance, which is a cooktop in the case of a cooking hob, by means of at least one spring element acting upon the user interface and/or upon the common housing, specifically when the user interface is securely fixed in and/or supported by the common housing.

The connection between the first and the second connection means may be a connection between contact points or contact surfaces, and at least one of the first and second connection means may be spring suspended. A related spring element or spring function may comprise or may be realized by at least one spiral spring and/or at least one leaf spring, which may be advantageous in this context. The spring protrudes from the circuit board and a free or distant end thereof particularly forms the first connection means. Alternatively, in an example not part of the invention, the spring, notably a free end thereof, may be resiliently bent away from the surface of the housing or frame part or carrier body, which free end particularly forms the second connection means.

A second example, not part of the present invention, is characterized in that the connection line electrically interconnects a first circuit board and a second circuit board arranged one above the other or in a stepped arrangement. Further, the connection line, which also in this preferred solution may be a conductor track or a metal strip, is guided alongside a side wall of a housing or a carrier body of the upper one of the first and second circuit boards. That way, the connection line electrically interconnects the first and the second circuit boards.

Moreover, one other example not part of the invention, provides for a connection line, which comprises a first line end or end section that contacts a contact point of the first circuit board. Further, a second line end or end section of the connection line contacts a contact point of the second circuit board. A contact pressure is provided between at least one of the first and second line ends or end sections and the related contact point of the allocated circuit board. The contact pressure is preferably performed by elastic force. The magnitude of said elastic force is selected in a way as to perform a bending of the connection line or specifically of the conductor track or metal strip, which bending is performed below the elastic limit of the material of the connection line.

The object is also achieved by a method for establishing an electrical connection of a printed circuit board according to the technical features of claim 10.

The method according to the present invention provides for an establishment of an electrical connection of a printed circuit board in the household appliance according to anyone of the afore-described embodiments and comprises the method steps
a. providing a surface of the carrier element with the connection line for an electrical connection for power and/or information transmission with the printed circuit board;
b. assembling the carrier element at or in the household appliance; and
c. mechanically connecting the carrier element and the printed circuit board, thereby establishing the electrical connection between the first connection means of the printed circuit board and the second connection means of the connection line arranged at a first line end or end section of the connection line.

Method step c. is executed after method step b. or, alternatively, they are executed in reverse order. In particular, the method steps b. and c. are performed in an assembly movement in a direction at least approximately orthogonally to a base area of the household appliance.

Above-mentioned term "thereby" may be understood by "at the same time" or "simultaneously".

The household appliance is particularly a cooking appliance and may be a cooking hob, in particular an electrically driven cooking hob. A specifically selected appliance is an induction cooking hob. A particularly preferred embodiment of the method according to the invention is characterized by applying a conductor track on an electrically insulated area of the surface of the carrier element, what may be performed by anyone of the known metallic coating processes.

The electrical connection means of the printed circuit board is the first connection means and the electrical connection means of the connection line is the second connection means, as they have been mention above when describing one of the preferred embodiments of the household appliance according to the present invention.

According to a first example, not part of the invention, of the method, the carrier element is a carrier body of a second circuit board and the above-described method steps b. and c. are executed in reverse order and defined by the method steps
c'. assembling the second circuit board on the carrier body, thereby establishing an electrical connection between an electrical connection means of the second circuit board and an electrical connection means of the connection line arranged at a first line end or end section of the connection line; and
b'. assembling the carrier body in the household appliance, thereby establishing an electrical connection between an electrical connection means of the connection line arranged at a second line end or end section of the connection line and an electrical connection means of a first circuit board arranged in the household appliance.

The above-mentioned term "in reverse order" means a chronological sequence of at first method step c'. and then method step b'..

Another embodiment of the method according to the invention, which is a second particularly preferred embodiment, is characterized by a carrier element being a common carrier element of a first circuit board and a second circuit board and the method step c. is defined by, particularly subdivided into, the method steps
c1. assembling the first circuit board on or at the carrier element, thereby establishing an electrical connection between an electrical connection means of the first circuit board and an electrical connection means of the connection line arranged at a first line end or end section of the connection line; and
c2. assembling the second circuit board on or at the carrier body, thereby establishing an electrical connection between an electrical connection means of the second circuit board and an electrical connection means of the connection line arranged at a second line end or end section of the connection line.

Said carrier element according to the second solution is a common housing configured to accommodate the first and second circuit boards. The first and second circuit boards are sequentially assembled, starting with the first circuit board, which may be mounted in the common housing close to or on a bottom wall of the common housing. Favourably, the second circuit board is finally mounted on top of, and particularly spaced from, the first circuit board.

The assembly movement, notably executed on the assembly line for the household appliance, for at least one of the first and second circuit boards may be performed in a top down movement. Preferably, also the electrical connection is established during, specifically at the end of, said assembly movement. More specifically, the electrical connection is established by
- the unmounted one of the first and second connection means approaching the already positioned one of the first and second connection means; and
- establishing the electrical connection by mounting the related element, i.e. the carrier element or the electric or electronic component, whatever is applicable.

Novel and inventive features of the present invention are set forth in the appended claims.

The present invention will be described in further detail with reference to the drawing, in which
- Fig. 1: illustrates the general structure of an induction cooking hob in an exploded perspective view, according to an example not part of the invention;
- Fig. 2: is a perspective top view of an assembled induction cooking hob designed similar to Fig. 1 including component groups;
- Fig. 3: is a detail of an enlarged cross-sectional view of the induction cooking hob according to Fig. 2 in perspective viewing direction as indicated by III - III in Fig. 2, forming a first solution, not part of the invention, for an electrical connection between a power board and a user interface;
- Fig. 4: is an exploded view of a second solution, according to the invention, for an electrical connection between a power board and a user interface of a cooking hob;
- Fig. 5: is an enlarged view of detail V according to Fig. 4;
- Fig. 6: is a top view of the arrangement of Fig. 4 in an assembled state; and
- Fig. 7: is a cross-sectional view of a perspective illustration of the arrangement according to Fig. 6, indicated in Fig. 6 by VII - VII.

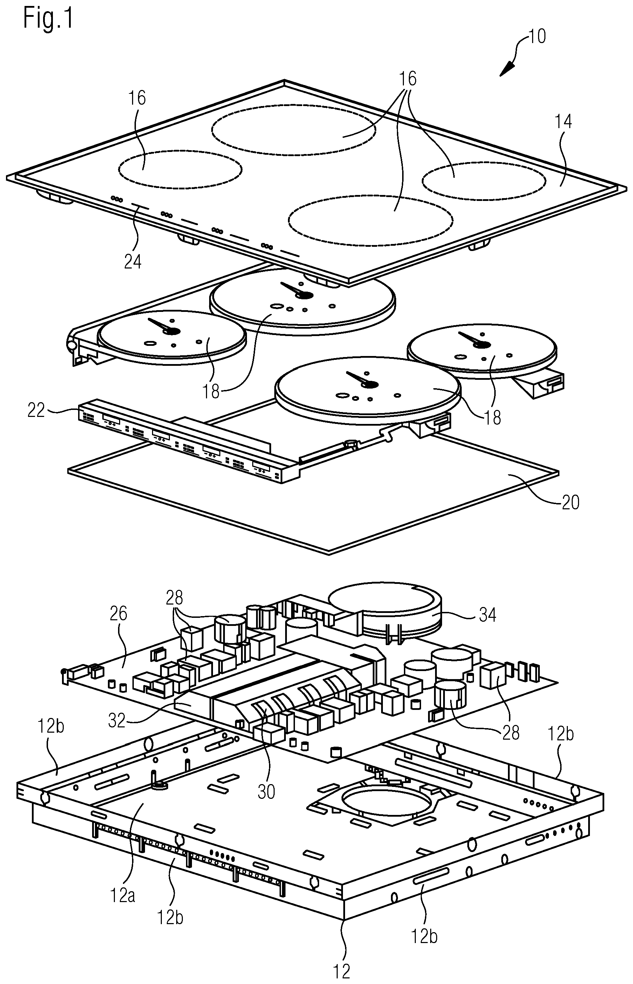

Fig. 1 illustrates an exploded perspective view of the general structure of a cooking hob 10.

The cooking hob 10 comprises a casing 12 and a panel 14. The casing 12 includes a bottom wall 12a, four sidewalls 12b and an open top side. Preferably, the casing 12 is made of metal, e.g. steel. Alternatively, the casing 12 may be made of plastics. The panel 14 covers the top side of the casing 12. For example, the panel 14 is a glass ceramic panel.

The cooking hob 10 comprises four circular cooking zones 16, two thereof with a smaller diameter, while the diameter of the other two cooking zones 16 are larger. The contours of the cooking zones 16 are indicated by respective circles on the top surface of the glass panel 14. Each cooking zone 16 receives its heating power from a heating element 18 arranged beneath the panel 14.

A carrier plate 20 supports the heating element 18. Said carrier plate 20 is arranged beneath the heating elements 18. The carrier plate 20 is a metallic plate, preferably made of an aluminium material, and may be of an extension adapted to carry all four heating elements 18, in that having dimensions close to the dimensions of the glass panel 14. Alternatively, four carrier plates 20 may be provided, each carrier plate 20 supporting merely one dedicated heating element 18.

The cooking hob 10 further comprises a user interface 22 for enabling user inputs including also a control panel for controlling the cooking hob functions. The user interface 22 includes touch sensors and display means corresponding with a user interface zone 24 arranged at the front edge of the glass panel 14.

Preferably, the heating element 18 is an electric heating element. At least one printed circuit board 26 is arranged above the bottom wall 12a of the casing 12. A plurality of electric and/or electronic elements 28, 30 is attached on the printed circuit board 26. The printed circuit board 26 including the electric and/or electronic elements 28, 30 forms a power board of the cooking hob 10. Power electronic elements 30 for supplying the heating elements 18 with electrical power are attached to a cooling channel 32, which extends horizontally through the cooking hob 10. An air stream driven by at least one fan 34 passes the cooling channel 32 and cools down the power electronic elements 30.

In this example, the cooking hob 10 is an induction cooking hob, wherein the heating element 18 is a heating coil unit 18 comprising an induction coil and the carrier plate 20 is a coil carrier.

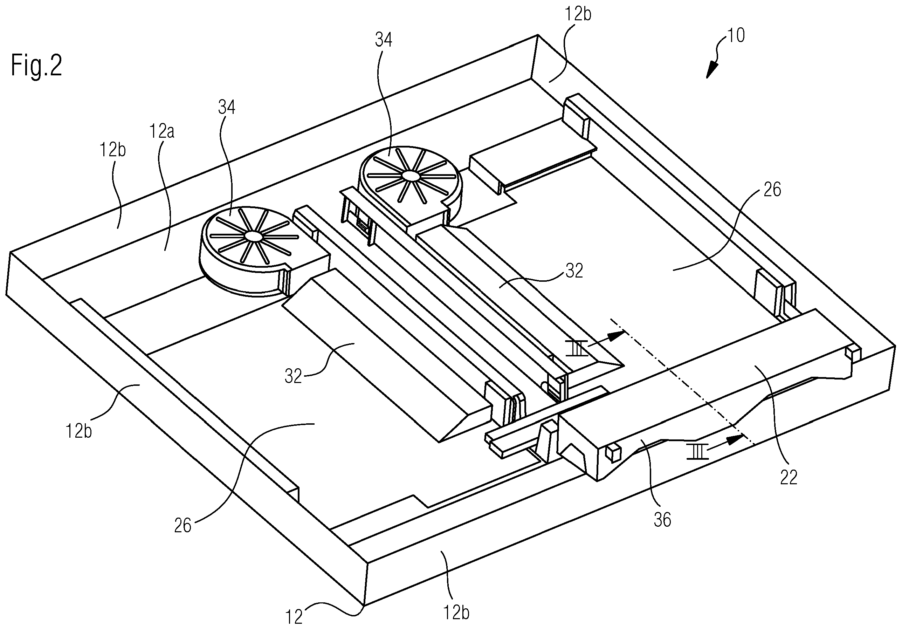

Fig. 2 illustrates schematically an assembled induction cooking hob 10 designed similar to Fig. 1. The assembly of Fig. 2 mainly differs from the solution of Fig. 1 in that the single power board 26 of Fig. 1, which is configured to supply all four cooking zones 16, is split into two power boards 26, each one thereof supplying two cooking zones 16 arranged one behind the other. Further, for the sake of clarity, Fig. 2 only shows the electrical components of the induction cooking hob 10 in the form of two power boards 26 and the user interface 22 arranged in the casing 12. Further components arranged above the power boards 26 and the user interface 22, e. g. heating coils units 18 and glass panel 14 are left out. Also the power boards 26 are illustrated only schematically, particularly without any electric and electronic parts, except their cooling channels 32 and associated fan 34. Moreover, the user interface 22 is also shown without any details, but it is indicated as being arranged in a user interface carrier 36 that is supported against the bottom wall 12a of the casing 12.

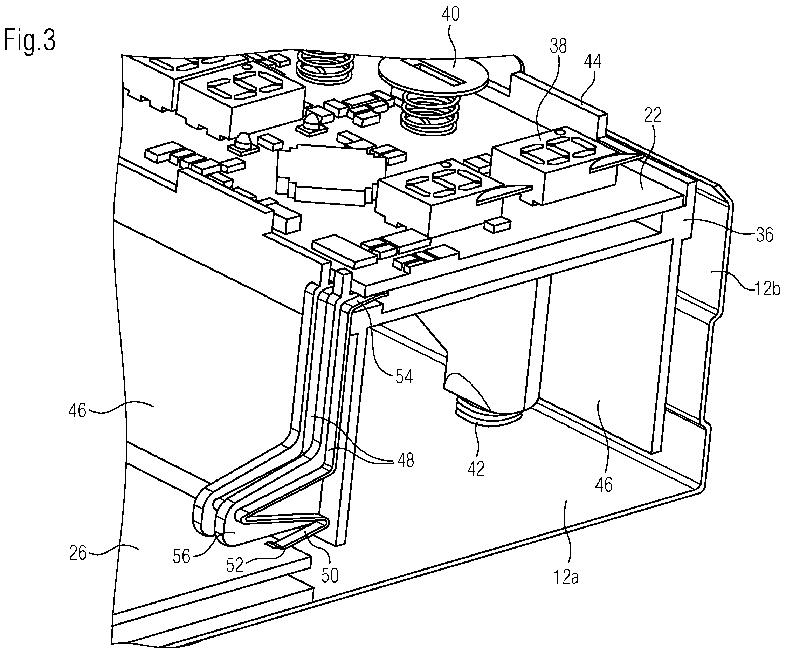

Fig. 3 illustrates a first example for an electrical connection between a power board 26 and a user interface 22 of the cooking hob 10. As can be seen in Figs. 2 and 3, the power board 26, notably that one arranged on the right side according to Fig. 2, and the user interface 22 are positioned inside the casing 12 in a stepped arrangement with the user interface 22 being supported by the user interface carrier 36 that is positioned at the front side of the cooking hob 10 and that is preferably made of a plastic material. With this positioning of the power board 26 and the user interface 22, an elevated arrangement level of the user interface 22 compared to that one of the power board 26 is established. The user interface carrier 36 itself is supported by the bottom wall 12a of the casing 12.

With Fig. 3 a detail of an enlarged cross-sectional view of the cooking hob according to Fig. 2 is illustrated in perspective viewing direction as indicated by III - III in Fig. 2. The user interface 22 is shown in more detail by illustrating electronic components arranged thereon, in particular seven segment display elements 38 and spring-loaded touch control elements 40 are visible. The touch control elements 40 are configured to be individually pressed against the bottom side of the glass panel 14 in order to guarantee proper functionality of the touch control operation. Additionally to the touch control elements 40, also the user interface carrier 36 is pushed upwardly by spring force, which is performed by means of a number of coil springs 42 (only one shown in Fig. 3) that are supported by the bottom wall 12a of the casing 12. Due to this sandwich-like arrangement of the user interface carrier 36 being clamped between the bottom wall 12 and the glass panel 14 by means of the coil springs 42, the interface carrier 36 is kept firmly in place. Spacer fins 44, supporting against the bottom side of the glass panel 14, care for a uniform resting of the circuit board of the user interface 22 on the glass panel 14 in an at least approximately parallel alignment.

The user interface 22 is electrically connected to the power board 26 by means of connection lines, which are guided alongside a vertically arranged wall-like pedestal 46 of the user interface carrier 36. In the present example, the connection lines are designed as conductor rails 48, which are formed from elongated metal strips and which are fixed to the plastic surface of the pedestals 46, which is positioned adjacent the power board 26. The electrical connection between the conductor rails 48 and the power board 26 is performed by means of spring-loaded lower end sections of the conductor rails 48, which are formed as folded leaf-springs 50 comprising a Z-shaped design, pressed against a related contact pad 52 on the upper side of the power board 26. On the other hand, the electrical connection between the conductor rails 48 and the user interface 22 is performed by means of also spring-loaded upper end sections of the conductor rails 48, which are designed as bent upper end portions 54 of the conductor rails 48 and which are pressed against a related contact pad (not shown) placed on the bottom side of the user interface 22. Since the folded leaf-springs 50 are positioned at the outer surface of the pedestal 46 of the user interface carrier 36, two adjacent conductor rails 48 including their related leaf-spring end sections 50 are electrically isolated from each other by means of a dividing wall 56, integrally formed with the pedestal 46 of the user interface carrier 36.

The present example according to Fig. 3 shows the electrical connection for the power supply of the user interface 22, supplied by respective conductor tracks on the power board 26, which are electrically coupled with power supply means of the cooking hob 10. Of course, the illustrated electrical connection may also be used for information transfer, what may have a smaller design due to lower power transfer compared to the shown power supply solution.

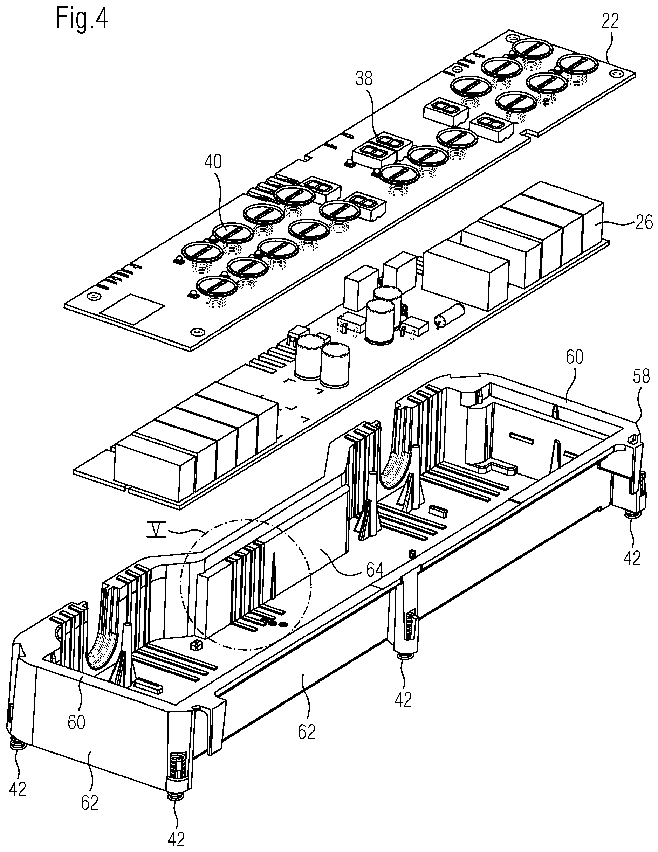

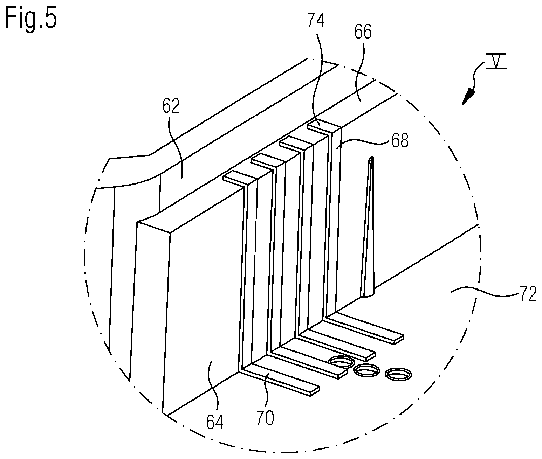

Figs. 4 to 7 illustrate a second example for an electrical connection between a power board 26 and a user interface 22 of the cooking hob 10. The cooking hob 10 of the second example is a radiant cooking hob, so that the respective power board 26 has a different design with notably smaller extensions. Said smaller extensions provide the possibility to arrange both the power board 26 and the user interface 22 in a common housing 58. Both circuit boards of the user interface 22 and the power board 26 are accommodated completely inside the housing 58. Only the spring-loaded touch control elements 40 project beyond a circumferential upper end face 60 of the side walls 62 of the common housing 58 as long as the common housing 58 and the accommodated user interface 22 and power board 26 are not mounted in the cooking hob 10 in the same sandwich-like arrangement as describe above with Fig. 3. Also the common housing 58 of the second example is pressed upwardly against the glass panel 14 by means of coil springs 42, while the circumferential upper end face 60 of the side walls 62 provide for a uniform resting of the common housing on the bottom side of the glass panel 14.

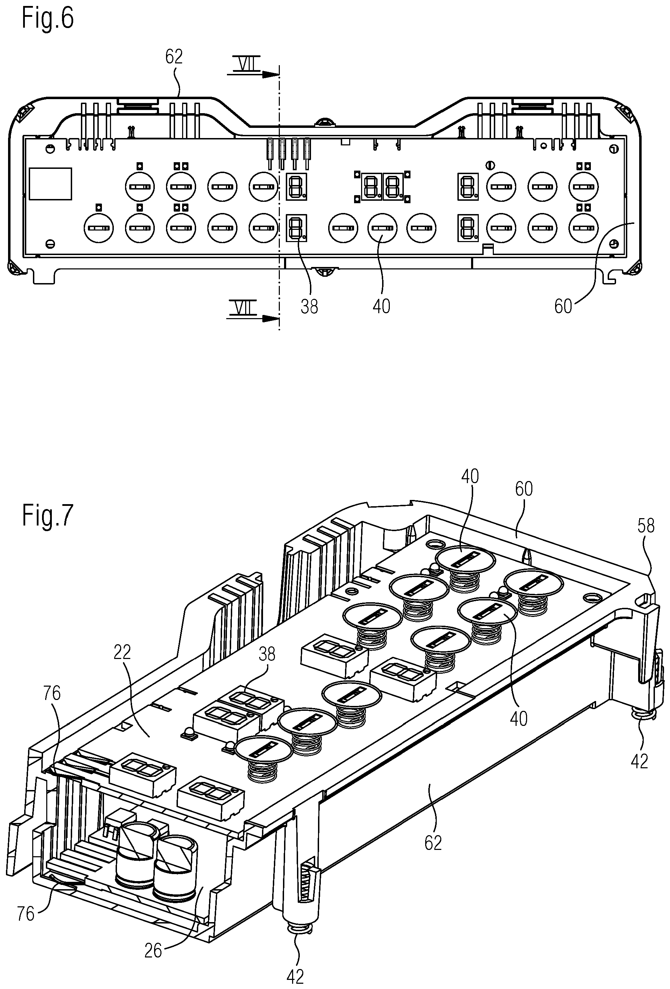

Similar to the first example, the electrical connection between the user interface 22 and the power board 26 is realized by means of connection lines guided alongside a non-conductive surface of a carrier element, which in the present second example is an exposed surface of a support wall 64. Said support wall 64 is arranged adjacent an inner surface of one of the longer side walls 62 of the common housing 58, which side wall 62 in the present example has an approximate Omega-shape, as can be best seen in Fig. 6. The support wall 64 has a lower height compared to the side walls 62 and its upper side 66 also works as a support surface for the bottom side of the circuit board of the user interface 22. Similar support walls are included in the interior of the common housing 58 for a proper support of the circuit board at distant support points, which further support walls are not illustrated in the figures.

The connection lines according to the second example are designed similar to the connection lines according to the first example. However, instead of providing conductor rails made of metal strips at the wall surface, the solution according to the second example provides for an application of conductor tracks 68, which may be made of a copper-zinc mixture, e.g. performed by evaporation deposition, onto the non-conductive surface of the support wall 64.

Also in the second example, the electrical contact between the conductor tracks 68 and the user interface 22 on the one hand, and the power board 26 on the other hand, are secured by spring-loaded connection means. However, contrary to the first example above, the spring-loaded connection means are not arranged at the connection line, as it is realized by the elements 50, 54 according to Fig. 3. Instead, the conductor tracks 68 are completely attached to the support wall 64, without sticking out therefrom. Moreover, the conductor tracks 68 are not only guided bottom-up along the vertical support wall 64. In fact, a lower end section 70 is bent by 90 degrees from its vertical course and is guided along a bottom plate 72 of the common housing 58, and an upper end section 74 is bent by 90 degrees from its vertical course and is guided along the upper side 66 of the support wall 64. In order to realize the above-indicated spring-loaded electrical connection in the second example, respective electrical connection means of both the user interface 22 and the power board 26 are designed as bent spring tongues 76 arranged at the edge of the related circuit boards of the user interface 22 and the power board 26, which edge is facing the support wall 64. Said arrangement is designed in a way that each spring tongue 76 is exactly locally assigned to its related lower or upper end section 70, 74 of the conductor tracks 68, wherein each end section 70, 74 is touched by the lower side of a bend of the related spring tongue 76. For a secure electrical connection, said bend of the spring tongue 76 slightly projects from the bottom side of the respective circuit board in an unstressed state of the spring tongue 76.

### List of reference numerals

- 10: cooking hob
- 12: casing
- 12a: bottom wall
- 12b: side walls
- 14: glass panel
- 16: cooking zones
- 18: heating coil units
- 20: coil carrier
- 22: user interface
- 24: user interface zone
- 26: power board
- 28,30: electric / electronic elements
- 32: cooling channel
- 34: fan
- 36: user interface carrier
- 38: seven segment display elements
- 40: touch control elements
- 42: coil springs
- 44: spacer fins
- 46: pedestal
- 48: conductor rails
- 50: leaf-springs
- 52: contact pad
- 54: upper end portions
- 56: dividing wall
- 58: common housing
- 60: upper end face
- 62: side walls
- 64: support wall
- 66: upper side
- 68: conductor tracks
- 70: lower end section
- 72: bottom plate
- 74: upper end section
- 76: spring tongues

## Claims

1. A household appliance (10), particularly a cooking appliance, more particularly a cooking hob, even more particularly an induction cooking hob, comprising a printed circuit board (22, 26), connected to a connection line (68) for electrical connection for power and/or information transmission, wherein the printed circuit board (22, 26) comprises a first connection means (76) and the connection line (68) comprises a second connection means (70, 74) for their interconnection, the connection line (68) is fixedly attached at least in the area of the second connection means (70, 74) to a, particularly inflexible, carrier element (58, 64), preferably a housing (58) or frame part or carrier body (64), wherein the carrier element (58, 64) and the printed circuit board (22, 26) are arrangeable or arranged inside or at the household appliance (10) in a way that the connection is established by defined positions and orientations of the carrier element (58, 64) and the printed circuit board relative to each other;
**characterized in that**
the connection line (68) electrically interconnects a first circuit board (26) and a second circuit board (22) arranged one above the other in a common housing (58), wherein the connection line (68), is guided alongside a housing side wall (62) or an inner wall (64) from the first circuit board (26) to the second (22) circuit board, the inner wall (64) being arranged inside the common housing (58) preferably adjacent to the housing side wall (62);
wherein a lower end section (70) of the connection line (68) is arranged on a bottom wall (72) of the common housing (58) and at least partially forms the second connection means that is electrically contacted from above by a spring, preferably by a spiral spring or a leaf-spring, preferably a spring tongue (76), protruding downwardly from a bottom side of the lower one of the first and second circuit boards (22, 26), forming the first connection means.

2. The household appliance (10) according to claim 1,
**characterized in that**
the connection between the first (76) and the second (70, 74) connection means is a plug-and-socket connection or a connection between contact points or contact surfaces, wherein a contact pressure between the contact points or contact surfaces is provided.

3. The household appliance (10) according to claim 1 or 2,
**characterized in that**
the first connection means is a contact point or contact surface arranged on a conductor track of a circuit board, in particular comprising a particularly conductive material or surface, the electrical connection preferably being designed to provide an installation condition with a two-dimensional, more preferably a three-dimensional, tolerance compensation.

4. The household appliance (10) according to anyone of the preceding claims,
**characterized in that**
the connection line is a conductor track (68), preferably applied by a metallic coating process, or a metal strip,
the conductor track (68) or the metal strip being arranged on an electrically non-conductive surface of the housing (58) or frame part or carrier body (64).

5. The household appliance (10) according to claim 4,
**characterized in that**
the housing (58) or frame part or carrier body (64) is made of a non-conductive material, preferably of a plastic material.

6. The household appliance (10) according to claim 4 or 5,
**characterized by**
a plurality of conductor tracks (68) or metal strips, preferably arranged in parallel and/or separated by a partition, particularly a partition or separation wall.

7. The household appliance (10) according any one of the preceding claims,
**characterized in that**
an upper end section (74) of the connection line (68), particularly of the conductor track, is arranged on an upper abutting face (66) of a housing side wall (62) or of an inner wall (64), the upper end section (74) and/or the upper abutting face (66) forming an abutment face for the first connection means and particularly also for an outer edge of the upper one of the first and second circuit boards (22, 26).

8. The household appliance (10) according to any one of the preceding claims,
**characterized in that**
the upper one of the first and second circuit boards (22, 26) is a user interface, which is pressed against an upper plate (14) of the household appliance (10), particularly against a cooktop of the cooking hob, by means of at least one spring element (42) acting upon the user interface (22) and/or upon the common housing (58), and the lower one of the first and second circuit boards (22, 26) is a power board of the household appliance (10).

9. The household appliance (10) according to anyone of the preceding claims,
**characterized in that**
the connection between the first (76) and the second (70, 74) connection means is a connection between contact points or contact surfaces, wherein at least one of the first (76) and second (70, 74) connection means is spring suspended, particularly using at least one spiral spring and/or at least one leaf spring (76), and wherein the spring (76) protrudes from the circuit board (22, 26).

10. A method for establishing an electrical connection of a printed circuit board (22, 26) in a household appliance (10) according to anyone of the claims 1 to 9, the method comprising the method steps
a. providing a surface of the carrier element (58, 64), with the connection line (68) for an electrical connection for power and/or information transmission with the printed circuit board (22, 26), preferably by applying a conductor track (68) on an electrically insulated area of the surface;
b. assembling or positioning the carrier element (58, 64) at or in the household appliance (10); and
c. mechanically connecting the carrier element (58, 64) and the printed circuit board (22, 26), thereby establishing the electrical connection between the first connection means (76) of the printed circuit board (22, 26), and the second connection means (70, 74) of the connection line (68) arranged at a first line end or end section of the connection line,
wherein method step c. is executed after method step b. or method step c. is executed before method step b ,
wherein the method steps b. and c. are particularly performed in an assembly movement in a direction at least approximately orthogonally to a base area (12a) of the household appliance (10).

11. The method according to claim 10,
**characterized in that**
the carrier element is a common housing (58), of the first circuit board (26) and the second circuit board (22) and the method step c. is defined by the method steps
c1. assembling the first circuit board (26) in the common housing (58), thereby establishing an electrical connection between an electrical connection means (76) of the first circuit board (26) and an electrical connection means of the connection line (68) arranged at a first line end or end section (70) of the connection line (68); and
c2. assembling the second circuit board (22) in the common housing (58), on top of the first circuit board (26), thereby establishing an electrical connection between an electrical connection means (76) of the second circuit board (22) and an electrical connection means of the connection line (68) arranged at a second line end or end section (74) of the connection line (68).

## Patentansprüche

1. Haushaltsgerät (10), insbesondere ein Kochgerät, insbesondere ein Kochfeld, insbesondere ein Induktionskochfeld, umfassend eine Leiterplatte (22, 26), verbunden mit einer Verbindungsleitung (68) für die elektrische Verbindung zur Strom- und/oder Informationsübertragung, wobei die Leiterplatte (22, 26) ein erstes Verbindungsmittel (76) und die Verbindungsleitung (68) ein zweites Verbindungsmittel (70, 74) für ihre Verbindung aufweist, wobei die Verbindungsleitung (68) zumindest im Bereich des zweiten Verbindungsmittels (70, 74) fest an einem besonders starren Trägerelement (58, 64), vorzugsweise einem Gehäuse (58) oder Rahmenteil oder Trägerkörper (64), befestigt ist, wobei das Trägerelement (58, 64) und die Leiterplatte (22, 26) innerhalb oder am Haushaltsgerät (10) so anordenbar oder angeordnet sind, dass die Verbindung durch definierte Positionen und Ausrichtungen des Trägerelements (58, 64) und der Leiterplatte relativ zueinander hergestellt wird;
**dadurch gekennzeichnet, dass**
die Verbindungsleitung (68) eine erste Leiterplatte (26) und eine zweite Leiterplatte (22) verbindet, die übereinander in einem gemeinsamen Gehäuse (58) angeordnet sind, wobei die Verbindungsleitung (68) entlang einer Gehäuseseitenwand (62) oder einer Innenwand (64) von der ersten Leiterplatte (26) zur zweiten (22) Leiterplatte geführt wird, wobei die Innenwand (64) innerhalb des gemeinsamen Gehäuses (58) vorzugsweise angrenzend an die Gehäuseseitenwand (62) angeordnet ist;
wobei ein unterer Endabschnitt (70) der Verbindungsleitung (68) an einer Bodenwand (72) des gemeinsamen Gehäuses (58) angeordnet ist und zumindest teilweise das zweite Verbindungsmittel bildet, das von oben durch eine Feder, vorzugsweise durch eine Spiralfeder oder eine Blattfeder, vorzugsweise eine Federzunge (76), die von einer Unterseite der unteren aus der ersten und zweiten Leiterplatte (22, 26) nach unten herausragt, elektrisch kontaktiert wird und das erste Verbindungsmittel bildet.

2. Haushaltsgerät (10) nach Anspruch 1,
**dadurch gekennzeichnet, dass**
die Verbindung zwischen dem ersten (76) und dem zweiten (70, 74) Verbindungsmittel eine Stecker- und Buchsenverbindung oder eine Verbindung zwischen Kontaktpunkten oder Kontaktflächen ist, wobei ein Kontaktdruck zwischen den Kontaktpunkten oder Kontaktflächen vorgesehen ist.

3. Haushaltsgerät (10) nach Anspruch 1 oder 2,
**dadurch gekennzeichnet, dass**
das erste Verbindungsmittel ein Kontaktpunkt oder eine Kontaktfläche ist, die auf einer Leiterbahn einer Leiterplatte angeordnet ist, insbesondere umfassend ein besonders leitfähiges Material oder eine Oberfläche, wobei die elektrische Verbindung vorzugsweise ausgebildet ist, um eine Installationsbedingung mit einer zweidimensionalen, vorzugsweise dreidimensionalen Toleranzkompensation zu schaffen.

4. Haushaltsgerät (10) nach einem der vorhergehenden Ansprüche,
**dadurch gekennzeichnet, dass**
die Verbindungsleitung eine Leiterbahn (68), vorzugsweise durch ein metallisches Beschichtungsverfahren aufgebracht, oder ein Metallband, ist, wobei die Leiterbahn (68) oder der Metallstreifen auf einer elektrisch nicht leitenden Oberfläche des Gehäuses (58) oder des Rahmenteils oder des Trägerkörpers (64) angeordnet ist.

5. Haushaltsgerät (10) nach Anspruch 4,
**dadurch gekennzeichnet, dass**
das Gehäuse (58) oder der Rahmenteil oder der Trägerkörper (64) aus einem nicht leitenden Material, vorzugsweise aus einem Kunststoffmaterial, besteht.

6. Haushaltsgerät (10) nach Anspruch 4 oder 5, **gekennzeichnet durch**
mehrere Leiterbahnen (68) oder Metallstreifen, vorzugsweise parallel angeordnet und/oder durch eine Trennwand getrennt, insbesondere eine Teilungs- oder Trennwand.

7. Haushaltsgerät (10) nach einem der vorhergehenden Ansprüche,
**dadurch gekennzeichnet, dass**
ein oberer Endabschnitt (74) der Verbindungsleitung (68), insbesondere der Leiterbahn, auf einer oberen Anschlagsfläche (66) einer Gehäuseseitenwand (62) oder einer Innenwand (64) angeordnet ist, wobei der obere Endabschnitt (74) und/oder die obere Anschlagsfläche (66) eine Anschlagsfläche für das erste Verbindungsmittel und insbesondere auch für eine Außenkante der oberen aus der ersten und zweiten Leiterplatte (22, 26) bildet.

8. Haushaltsgerät (10) nach einem der vorhergehenden Ansprüche,
**dadurch gekennzeichnet, dass**
die obere aus der ersten und zweiten Leiterplatte (22, 26) eine Benutzerschnittstelle ist, die mittels mindestens eines Federelements (42), das auf die Benutzerschnittstelle (22) und/oder das gemeinsame Gehäuse (58) wirkt, gegen eine obere Platte (14) des Haushaltsgeräts (10), insbesondere gegen eine Kochplatte des Kochfelds gedrückt wird, und die untere aus der ersten und zweiten Leiterplatte (22, 26) eine Stromversorgungsplatine des Haushaltsgeräts (10) ist.

9. Haushaltsgerät (10) nach einem der vorhergehenden Ansprüche,
**dadurch gekennzeichnet, dass**
die Verbindung zwischen dem ersten (76) und dem zweiten (70, 74) Verbindungsmittel eine Verbindung zwischen Kontaktpunkten oder Kontaktflächen ist, wobei mindestens eines aus dem ersten (76) und zweiten (70, 74) Verbindungsmittel federaufgehängt ist, insbesondere unter Verwendung mindestens einer Spiralfeder und/oder mindestens einer Blattfeder (76), und wobei die Feder (76) aus der Leiterplatte (22, 26) herausragt.

10. Verfahren zum Herstellen einer elektrischen Verbindung einer Leiterplatte (22, 26) in einem Haushaltsgerät (10) nach einem der Ansprüche 1 bis 9, wobei das Verfahren die folgenden Verfahrensschritte umfasst:
a. Bereitstellen einer Oberfläche des Trägerelements (58, 64) mit der Verbindungsleitung (68) für eine elektrische Verbindung zur Strom- und/oder Informationsübertragung mit der Leiterplatte (22, 26), vorzugsweise durch Anbringen einer Leiterbahn (68) auf einem elektrisch isolierten Bereich der Oberfläche;
b. Montieren oder Positionieren des Trägerelements (58, 64) am oder im Haushaltsgerät (10) und
c. mechanisches Verbinden des Trägerelements (58, 64) und der Leiterplatte (22, 26), wodurch die elektrische Verbindung zwischen dem ersten Verbindungsmittel (76) der Leiterplatte (22, 26) und dem zweiten Verbindungsmittel (70, 74) der Verbindungsleitung (68) hergestellt wird, die an einem ersten Leitungsende oder Endabschnitt der Verbindungsleitung angeordnet ist,
wobei Verfahrensschritt c. nach Verfahrensschritt b. ausgeführt wird oder Verfahrensschritt c. vor Verfahrensschritt b. ausgeführt wird,
wobei die Verfahrensschritte b. und c. besonders in einer Montagebewegung in einer Richtung durchgeführt werden, die mindestens annähernd orthogonal zu einer Grundfläche (12a) des Haushaltsgeräts (10) liegt.

11. Verfahren nach Anspruch 10,
**dadurch gekennzeichnet, dass**
das Trägerelement ein gemeinsames Gehäuse (58) ist, bestehend aus der ersten Leiterplatte (26) und der zweiten Leiterplatte (22), und dass der Verfahrensschritt c. durch die folgenden Verfahrensschritte definiert ist:
c1. Montieren der ersten Leiterplatte (26) im gemeinsamen Gehäuse (58)
dadurch eine elektrische Verbindung zwischen einem elektrischen Verbindungsmittel (76) der ersten Leiterplatte (26) und einem elektrischen Verbindungsmittel der Verbindungsleitung (68), angeordnet an einem ersten Leitungsende oder Endabschnitt (70) der Verbindungsleitung (68), herstellend, und
c2. Montieren der zweiten Leiterplatte (22) im gemeinsamen Gehäuse (58)
oben auf der ersten Leiterplatte (26),
dadurch eine elektrische Verbindung zwischen einem elektrischen Verbindungsmittel (76) der zweiten Leiterplatte (22) und einem elektrischen Verbindungsmittel der Verbindungsleitung (68), angeordnet an einem zweiten Leitungsende oder Endabschnitt (74) der Verbindungsleitung (68), herstellend.

## Revendications

1. Appareil ménager (10), particulièrement un appareil de cuisson, plus particulièrement une table de cuisson, encore plus particulièrement une table de cuisson à induction, comprenant une carte de circuit imprimé (22, 26), connectée à une ligne de connexion (68) pour connexion électrique pour transmission de puissance et/ou d'informations, dans lequel la carte de circuit imprimé (22, 26) comprend un premier moyen de connexion (76) et la ligne de connexion (68) comprend un second moyen de connexion (70, 74) pour leur interconnexion, la ligne de connexion (68) est attachée de façon fixe au moins dans la zone du second moyen de connexion (70, 74) à un élément support, particulièrement inflexible, (58, 64), de préférence un boîtier (58) ou une partie cadre ou un corps support (64), dans lequel l'élément support (58, 64) et la carte de circuit imprimé (22, 26) sont agençables ou agencés à l'intérieur, ou au niveau, de l'appareil ménager (10) de manière telle que la connexion est établie par des positions et orientations définies de l'élément support (58, 64) et de la carte de circuit imprimé l'un relativement à l'autre ;
**caractérisé en ce que**
la ligne de connexion (68) interconnecte électriquement une première carte de circuit (26) et une seconde carte de circuit (22) agencées l'une au-dessus de l'autre dans un boîtier commun (58), dans lequel la ligne de connexion (68), est guidée le long d'une paroi latérale de boîtier (62) ou d'une paroi interne (64) depuis la première carte de circuit (26) jusqu'à la seconde carte de circuit (22), la paroi interne (64) étant agencée à l'intérieur du boîtier commun (58) de préférence de façon adjacente à la paroi latérale de boîtier (62) ;
dans lequel une section d'extrémité inférieure (70) de la ligne de connexion (68) est agencée sur une paroi de fond (72) du boîtier commun (58) et forme au moins partiellement le second moyen de connexion qui subit un contact électrique à partir d'au-dessus par un ressort, de préférence par un ressort en spirale ou un ressort à lame, de préférence une langue-ressort (76), faisant saillie vers le bas depuis un côté bas de la carte de circuit inférieure des première et seconde cartes de circuit (22, 26), formant le premier moyen de connexion.

2. Appareil ménager (10) selon la revendication 1,
**caractérisé en ce que**
la connexion entre le premier (76) et le second (70, 74) moyens de connexion est une connexion fiche-et-prise ou une connexion entre des points de contact ou des surfaces de contact, dans lequel une pression de contact entre les points de contact ou surfaces de contact est prévue.

3. Appareil ménager (10) selon la revendication 1 ou 2,
**caractérisé en ce que**
le premier moyen de connexion est un point de contact ou une surface de contact agencé(e) sur une piste conductrice d'une carte de circuit, en particulier comprenant un matériau ou une surface particulièrement conducteur ou conductrice, la connexion électrique étant de préférence conçue pour fournir une condition d'installation avec une compensation de tolérance bidimensionnelle, mieux encore tridimensionnelle.

4. Appareil ménager (10) selon l'une quelconque des revendications précédentes,
**caractérisé en ce que**
la ligne de connexion est une piste conductrice (68), de préférence appliquée par un processus d'application de revêtement métallique, ou une bande métallique, la piste conductrice (68) ou la bande métallique étant agencée sur une surface électriquement non conductrice du boîtier (58) ou de la partie cadre ou du corps support (64).

5. Appareil ménager (10) selon la revendication 4,
**caractérisé en ce que**
le boîtier (58) ou la partie cadre ou corps support (64) est fait(e) d'un matériau non conducteur, de préférence d'un matériau plastique.

6. Appareil ménager (10) selon la revendication 4 ou 5,
**caractérisé par**
une pluralité de pistes conductrices (68) ou de bandes métalliques, de préférence agencées en parallèle et/ou séparées par une cloison de séparation, particulièrement une cloison de séparation ou paroi de séparation.

7. Appareil ménager (10) selon l'une quelconque des revendications précédentes,
**caractérisé en ce que**
une section d'extrémité supérieure (74) de la ligne de connexion (68), particulièrement de la piste conductrice, est agencée sur une face de butée supérieure (66) d'une paroi latérale de boîtier (62) ou d'une paroi interne (64), la section d'extrémité supérieure (74) et/ou la face de butée supérieure (66) formant une face de butée pour le premier moyen de connexion et particulièrement également pour un bord externe de l'une supérieure des première et seconde cartes de circuit (22, 26).

8. Appareil ménager (10) selon l'une quelconque des revendications précédentes,
**caractérisé en ce que**
l'une supérieure des première et seconde cartes de circuit (22, 26) est une interface utilisateur, qui est pressée contre une plaque supérieure (14) de l'appareil ménager (10), particulièrement contre une surface de cuisson de la table de cuisson, au moyen d'au moins un élément ressort (42) agissant sur l'interface utilisateur (22) et/ou sur le boîtier commun (58), et l'une inférieure des première et seconde cartes de circuit (22, 26) est une carte de puissance de l'appareil ménager (10).

9. Appareil ménager (10) selon l'une quelconque des revendications précédentes,
**caractérisé en ce que**
la connexion entre le premier (76) et le second (70, 74) moyens de connexion est une connexion entre des points de contact ou des surfaces de contact, dans lequel au moins un des premier (76) et second (70, 74) moyens de connexion est suspendu par ressort, particulièrement en utilisant au moins un ressort en spirale et/ou au moins un ressort à lame (76), et dans lequel le ressort (76) fait saillie à partir de la carte de circuit (22, 26).

10. Procédé pour établir une connexion électrique d'une carte de circuit imprimé (22, 26) dans un appareil ménager (10) selon l'une quelconque des revendications 1 à 9,
le procédé comprenant les étapes de procédé
a. la fourniture d'une surface de l'élément support (58, 64), avec la ligne de connexion (68) pour une connexion électrique pour la transmission de puissance et/ou d'informations avec la carte de circuit imprimé (22, 26), de préférence en appliquant une piste conductrice (68) sur une zone électriquement isolée de la surface ;
b. l'assemblage ou le positionnement de l'élément support (58, 64) au niveau de l'appareil ménager (10) ou dans celui-ci ; et
c. la connexion mécanique de l'élément support (58, 64) et de la carte de circuit imprimé (22, 26), établissant ainsi la connexion électrique entre le premier moyen de connexion (76) de la carte de circuit imprimé (22, 26), et le second moyen de connexion (70, 74) de la ligne de connexion (68) agencé au niveau d'une première extrémité de ligne ou section d'extrémité de la ligne de connexion, dans lequel l'étape de procédé c. est exécutée après l'étape de procédé b. ou l'étape de procédé c. est exécutée avant l'étape de procédé b,
dans lequel les étapes de procédé b. et c. sont particulièrement réalisées dans un mouvement d'assemblage dans une direction au moins approximativement orthogonale à une zone de base (12a) de l'appareil ménager (10).

11. Procédé selon la revendication 10,
**caractérisé en ce que**
l'élément support est un boîtier commun (58), de la première carte de circuit (26) et de la seconde carte de circuit (22), et l'étape de procédé c. est définie par les étapes de procédé
c1. l'assemblage de la première carte de circuit (26) dans le boîtier commun (58),
établissant ainsi une connexion électrique entre un moyen de connexion électrique (76) de la première carte de circuit (26) et un moyen de connexion électrique de la ligne de connexion (68) agencée au niveau d'une première extrémité de ligne ou section d'extrémité (70) de la ligne de connexion (68) ; et
c2. l'assemblage de la seconde carte de circuit (22) dans le boîtier commun (58),
par-dessus la première carte de circuit (26), établissant ainsi une connexion électrique entre un moyen de connexion électrique (76) de la seconde carte de circuit (22) et un moyen de connexion électrique de la ligne de connexion (68) agencée au niveau d'une seconde extrémité de ligne ou section d'extrémité (74) de la ligne de connexion (68).
